# EUROPEAN PATENT SPECIFICATION

(11) **EP 2 419 591 B1**
(45) Date of publication and mention of the grant of the patent: **02.07.2014**
(21) Application number: 10713206.0
(22) Date of filing: 09.04.2010
(51) Int. Cl.: E05F 15/10, G01R 31/34, H01R 39/58, H01R 39/62

(54) **IMPROVED DOOR SYSTEM**
VERBESSERTES TÜRSYSTEM
SYSTÈME DE PORTE AMÉLIORÉ

(30) Priority: 16.04.2009 SE 0900506
(43) Date of publication of application: 22.02.2012
(73) Proprietor: ASSA ABLOY Entrance System AB, 261 22 Landskrona (SE)
(72) Inventor: DREYER, Roger Juel, S-237 91 Bjärred (SE)
(74) Representative: Aurell, Henrik
(86) International application number: PCT/EP2010/054676
(87) International publication number: WO 2010/118984

(56) References cited:
- DE-A1- 19 619 728
- DE-C- 740 379
- US-A1- 2006 244 271

## Description

### Technical field

The present invention relates to a door system with an electric motor that is configured to operate a door in the door system.

### Background

Doors that open and close automatically have been widely used for a long time now. Such doors are in most implementations operated by electric motors, such as direct current (DC) motors. The door operation motors are often controlled by control devices that sense an approaching person and/or control devices that electronically authenticates and authorizes persons before controlling the motor to open or close the door.

A door system according to the preamble of claim 1 is disclosed in US2006/244271A1.

Depending on where such automatic doors are situated, i.e. depending on the number of open and close cycles experienced by the doors, the lifetime of the electric components of the motors may vary to a large extent. This is a safety issue that has been recognized and the use of automatic doors in escape routes has in some legislations resulted in directives pointing out requirements regarding redundancy. Such requirements are often fulfilled by the use of plural independent systems to ensure that the door always can open in event of escape. A common way of solving that is to apply two motors and two electronic control systems connected to the motors for ensuring the safety critical functionality.

US 2,775, 717 and US 6,873,083 address the problem of how to extend the lifetime of a brush assembly in a DC motor by incorporating two or more carbon brushes, a first brush and a second brush. As the motor is used the first brush is worn away until approaching end of useful life, when a trip mechanism arranged at the brushes causes the first brush to retract from the commutator and the second brush to get in contact with the commutator.

A drawback of such arrangements is that, although they may be used to extend the operational lifetime of an automatic door system, they do not provide the redundancy that is needed in order to fulfill many safety requirements in escape routes.

### Summary

In order to improve on prior art solutions there is provided, according to a first aspect, a door system comprising a door, a direct current, DC, electric motor configured to operate the door and a control unit. The DC motor comprises a first pair of brushes arranged at a commutator of the DC motor and configured to be connected to at least a first source of electric power, and a second pair of brushes arranged at the commutator of the DC motor and configured to be connected to at least a second source of electric power. The control unit is configured to detect damage to the first pair of brushes and, in dependence of such detection, disconnect the first pair of brushes from the first source of electric power and connect the second pair of brushes to the second source of electric power.

The first pair of brushes may configured to be connected to an alternating current, AC, source via a rectifier unit, and the second pair of brushes may be configured to be connected to a battery.

Furthermore, the control unit may be configured to detect damage to the first pair of brushes by way of performing a measurement of at least one electric property of the first pair of brushes.

Similarly, in a second aspect, there is provided a method of controlling a door system. The method comprises detecting damage to a first pair of brushes arranged at a commutator of the DC motor and, in dependence of the detection, disconnecting the first pair of brushes from a first source of electric power and connecting a second pair of brushes to a second source of electric power.

The detection of damage to the first pair of brushes may comprise performing a measurement of at least one electric property of the first pair of brushes.

In other words, the drawbacks as discussed above are addressed by providing a door system with a redundant second channel of power that can be utilized when a first channel of power has been damaged. That is, safety critical functionality is maintained in an automatic door even when the main brushes in the DC motor are worn out.

The control unit has the ability to identify, e.g. by making electrical measurements, that one pair of brushes is worn out or damaged. The control system can then disconnect power from the first channel and connect power from the second channel and then enable use of the second pair of brushes to drive the door to a selected safe position or performing a final, maybe critical, action, during an emergency situation such as an evacuation.

The second pair of brushes that may be considered as spare, or only used in case of a failure, is not worn out to the same degree as the first pair that is used for normal use. There is no current floating through the second pair of brushes, possibly with the exception during testing of the redundant second power channel provided via the second pair of brushes. This means that the second pair of brushes lasts longer, and since both pairs of brushes operate with one and the same commutator and windings in the DC motor, the solution as summarized will be simple and cost efficient.

### Brief description of the drawings

Embodiments will now be described with reference to the attached drawings, where:
figure 1 is a block diagram that schematically illustrates a door system,
figure 2 is a perspective view that schematically illustrates a DC motor, and
figure 3 is a flowchart of a control sequence.

### Detailed description of embodiments

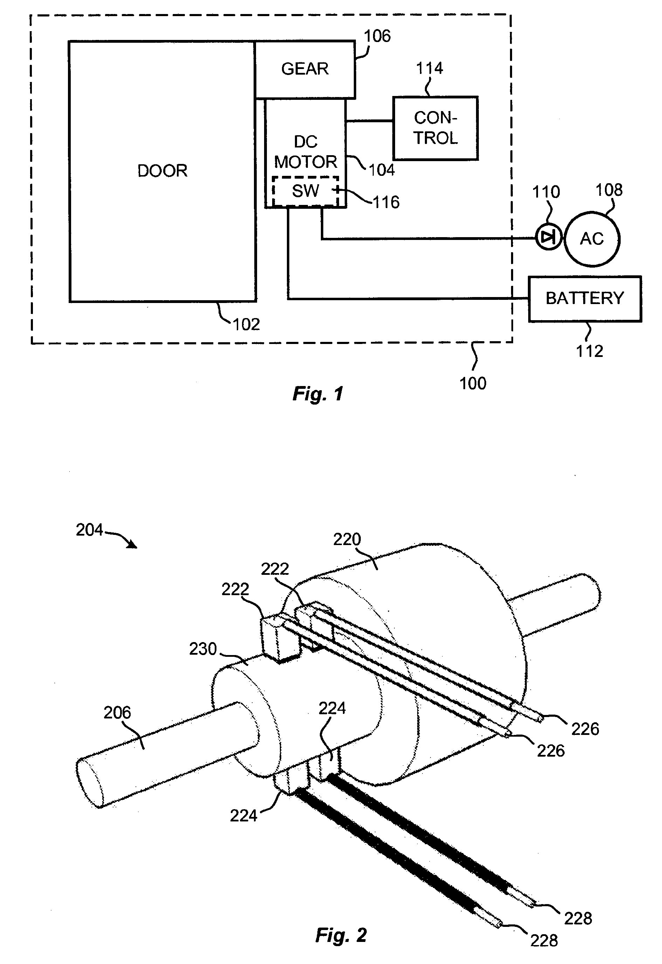

Figure 1 is a block diagram of a door system 100 as summarized above. The door system 100 comprises a door 102 and a DC motor 104 that is configured to open and close the door 102 via mechanical interface means 106. The mechanical interface means 106 typically comprises gears and levers that are capable of converting rotary motion in the motor 104 to appropriate motion of the door 102, noting that the door 102 may be any type of door known in the art that is capable of being operated by a motor. Examples of such door types include swing doors, sliding doors and revolving doors.

An electronic control unit 114, connected to the motor 104, is configured such that it is capable of, by help of an electric switch 116, connecting and disconnecting the motor 106 to a first electric power source 108 and a second electric power source 112. The door system 100 is in this embodiment capable of being connected to an AC outlet 108 via a rectifying unit 110 as well as a DC source in the form of a battery 112.

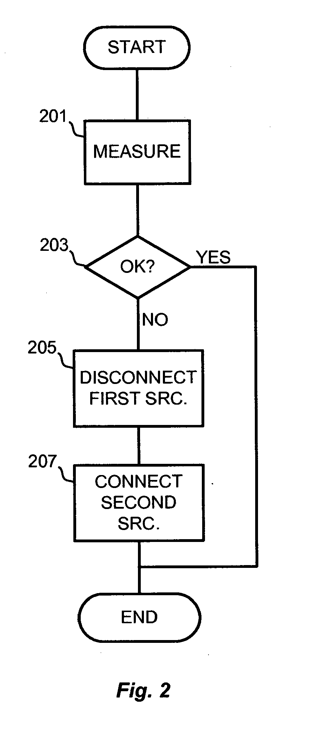

Turning now to figure 2, a DC motor 204 that is suitable for use in a door system, such as the system 100 of figure 1, will be described in some more detail. It is to be noted that the motor 204 is schematically represented in figure 2 and many details that are common to most DC motors have been omitted for the sake of clarity.

The motor 204 comprises a rotation axle 206, a commutator 230 and winding 220. The axle 206 is configured to be interfaced, via mechanical interface means such as the mechanical interface means 106 in figure 1, to a door such as the door 102 in figure 1. A first pair of brushes 222 and a second pair of brushes 224 are arranged at the commutator 230. Electric power is provided to the first pair of brushes 222 via first electric leads 226 and electric power is provided to the second pair of brushes 224 via second electric leads 228. Although not explicitly shown in figure 2, the electric leads 226, 228 are connected via an electric switch, such as the switch 116 in figure 1 controlled by a control unit such as the control unit 114 in figure 1, to a respective power source such as the first power source 108 and the second power source 112 in figure 1. Any of the first pair of brushes 222 and the second pair of brushes 224 may be connected to any power source, such as any of the first power source 108 and the second power source 112 in figure 1.

Turning now to figure 3, control of a DC motor such as the motor 104 in figure 1 and the motor 204 in figure 2 will be described. The control is performed by means of a control unit such as the control unit 114 in figure 1, together with sensors and actuators suitable for detecting electric characteristics in the motor and operating switching units such as the switching unit 116 in figure 1. As the skilled person will realize, the control is typically realized by way of software that is stored in memory and executed by a processing unit within the control unit.

An initial state is that of the motor being provided with electric power from a first electric power source through a first pair of brushes, as described above in connection with figure 1. In a measuring step 201, sensing and detecting of electric characteristic is performed together with processing of these characteristics to the extent that it can be determined whether or not the first pair of brushes are damaged. A decision based on this measurement is then taken in a decision step 203. If it is found that the first pair of brushes are damaged, the first pair of brushes are disconnected from the first power source in a disconnection step 205, and the second pair of brushes are connected to the second power source in a connection step 207.

## Claims

1. A door system (100) comprising a door (102), a direct current, DC, electric motor (104) configured to operate the door and a control unit (114), where the DC motor
comprises a first pair of brushes (222) arranged at a commutator (230) of the DC motor and configured to be connected to at least a first source of electric power (108), the door system being **characterised in that** the DC motor comprises a second pair of brushes (224) arranged at the commutator of the DC motor and configured to be connected to at least a second source of electric power (112), the control unit being
configured to detect damage to the first pair of brushes and, in dependence of such detection, disconnect the first pair of brushes from the first source of electric power and connect the second pair of brushes to the second source of electric power.

2. The door system of claim 1, wherein:
- the first pair of brushes is configured to be connected to an alternating current, AC, source via a rectifier unit (110), and
- the second pair of brushes is configured to be connected to a battery.

3. The door system of claim 1 or 2, wherein:
- the control unit is configured to detect damage to the first pair of brushes by way of performing a measurement of at least one electric property of the first pair of brushes.

4. A method of controlling a door system (100) that comprises a door (102), a direct current, DC, electric motor (104) configured to operate the door, the method comprising:
- detecting (201) damage to a first pair of brushes (222) arranged at a commutator (230) of the DC motor,
- in dependence of the detection, disconnecting (205) the first pair of brushes from a first source of electric power (108) and connecting (207) a second pair of brushes (224) arranged at the commutator of the DC motor to a second source of electric power (112).

5. The method of claim 4, wherein:
- detecting damage to the first pair of brushes comprises performing a measurement of at least one electric property of the first pair of brushes.

## Patentansprüche

1. Türsystem (100), umfassend eine Tür (102), einen Gleichstrom-, DC, Elektromotor (104), der für den Betrieb der Tür ausgelegt ist, und eine Steuereinheit (114), wobei der Gleichstrommotor ein erstes Paar von Bürsten (222) umfasst, die an einem Kommutator (230) des Gleichstrommotors angeordnet sind und dafür ausgelegt sind, mit zumindest einer ersten Quelle von elektrischer Leistung (108) verbunden zu werden, wobei das Türsystem **dadurch gekennzeichnet ist, dass** der Gleichstrommotor ein zweites Paar von Bürsten (224) umfasst, die am Kommutator des Gleichstrommotors angeordnet sind und dafür ausgelegt sind, mit zumindest einer zweiten Quelle von elektrischer Leistung (112) verbunden zu werden, wobei die Steuereinheit für das Erfassen einer Beschädigung des ersten Paares von Bürsten und in Abhängigkeit eines solchen Erfassens für das Trennen des ersten Paares von Bürsten von der ersten Quelle von elektrischer Leistung und für das Verbinden des zweiten Paares von Bürsten mit der zweiten Quelle von elektrischer Leistung ausgelegt ist.

2. Türsystem nach Anspruch 1, wobei:
- das erste Paar von Bürsten dafür ausgelegt ist, mit einer Wechselstrom-, AC, quelle über eine Gleichrichtereinheit (110) verbunden zu werden, und
- das zweite Paar von Bürsten dafür ausgelegt ist, mit einer Batterie verbunden zu werden.

3. Türsystem nach Anspruch 1 oder 2, wobei:
- die Steuereinheit für das Erfassen einer Beschädigung des ersten Paares von Bürsten ausgelegt ist, indem sie eine Messung von zumindest einer elektrischen Eigenschaft des ersten Paares von Bürsten ausführt.

4. Verfahren zur Steuerung eines Türsystems (100), umfassend eine Tür (102), einen Gleichstrom-, DC, Elektromotor (104), der für den Betrieb der Tür ausgelegt ist, wobei das Verfahren Folgendes umfasst:
- das Erfassen (201) einer Beschädigung eines ersten Paares von Bürsten (222), die an einem Kommutator (230) des Gleichstrommotors angeordnet sind,
- in Abhängigkeit des Erfassens, das Trennen (205) des ersten Paares von Bürsten von einer ersten Quelle von elektrischer Leistung (108) und das Verbinden (207) eines zweiten Paares von am Kommutator des Gleichstrommotors angeordneten Bürsten (224) mit einer zweiten Quelle von elektrischer Leistung (112).

5. Verfahren nach Anspruch 4, wobei:
- das Erfassen einer Beschädigung des ersten Paares von Bürsten die Ausführung einer Messung von zumindest einer elektrischen Eigenschaft des ersten Paares von Bürsten umfasst.

## Revendications

1. Système de porte (100) comprenant une porte (102), un moteur électrique à courant continu, CC, (104) configuré pour faire fonctionner la porte et une unité de commande (114), le moteur à CC comprenant une première paire de brosses (222) disposées au niveau d'un commutateur (230) du moteur à CC et configurées pour être connectées à au moins une première source d'énergie électrique (108), le système de porte étant **caractérisé en ce que** le moteur à CC comprend une deuxième paire de brosses (224) disposées au niveau du commutateur du moteur à CC et configurées pour être connectées à au moins une deuxième source d'énergie électrique (112), l'unité de commande étant configurée pour détecter des dommages à la première paire de brosses et, en fonction d'une telle détection, déconnecter la première paire de brosses de la première source d'énergie électrique et connecter la deuxième paire de brosses à la deuxième source d'énergie électrique.

2. Système de porte selon la revendication 1, dans lequel:
- la première paire de brosses est configurée pour être connectée à une source de courant alternatif, CA, par l'intermédiaire d'une unité de redressement (110), et
- la deuxième paire de brosses est configurée pour être connectée à une batterie.

3. Système de porte selon la revendication 1 ou 2, dans lequel:
- l'unité de commande est configurée pour détecter des dommages à la première paire de brosses au moyen de l'exécution d'une mesure d'au moins une propriété électrique de la première paire de brosses.

4. Procédé de commande d'un système de porte (100) qui comprend une porte (102), un moteur électrique à courant continu, CC, (104) configuré pour faire fonctionner la porte, le procédé comprenant:
- détecter (201) des dommages à une première paire de brosses (222) disposée au niveau d'un commutateur (230) du moteur à CC,
- en fonction d'une telle détection, déconnecter (205) la première paire de brosses de la première source d'énergie électrique (108) et connecter (207) une deuxième paire de brosses (224) disposée au niveau du commutateur du moteur à CC à la deuxième source d'énergie électrique (112).

5. Procédé selon la revendication 4, dans lequel:
- la détection des dommages à la première paire de brosses comprend l'exécution d'une mesure d'au moins une propriété électrique de la première paire de brosses.
